# DEMANDE DE BREVET EUROPEEN

(11) **EP 2 922 097 A1**
(43) Date de publication de la demande: **23.09.2015**
(21) Numéro de dépôt: 15158080.0
(22) Date de dépôt: 06.03.2015
(51) Int. Cl.: H01L 31/0216, C23C 14/00, G02B 1/11

(54) **Procédé d'optimisation du rendement quantique d'une photodiode**

(30) Priorité: 20.03.2014 FR 1452334
(71) Demandeur: COMMISSARIAT A L'ENERGIE ATOMIQUE ET AUX ENERGIES ALTERNATIVES, 75015 Paris (FR); STmicroelectronics SA, 92120 Montrouge (FR)
(72) Inventeur: Frey, Laurent, 38600 Fontaine (FR); Marty, Michel, 38760 Saint Paul de Varces (FR)
(74) Mandataire: Thibon, Laurent

(57) **Abrégé**

L'invention concerne un procédé d'optimisation du rendement quantique d'une photodiode dont la partie active (29) est formée dans un substrat en silicium (1) et est recouverte d'un empilement de couches isolantes comprenant successivement au moins une première couche (9) d'oxyde de silicium d'épaisseur comprise entre 5 et 50 nm, une couche antireflet (11) d'épaisseur comprise entre 10 et 80 nm, et une deuxième couche (31) d'oxyde de silicium, le procédé d'optimisation comprenant les étapes suivantes : déterminer pour une longueur d'onde infrarouge des premières épaisseurs (e1, e2, e3, e4 ... e8) de la deuxième couche (31) correspondant à des maxima d'absorption (M1, M2, M3, M4 ... M8) de la photodiode, et choisir, parmi les premières épaisseurs, une épaisseur désirée, eoxD, pour que la dispersion maximale de fabrication soit inférieure à la moitié de la pseudo-période séparant deux maxima successifs.

## Description

### Domaine

La présente demande concerne les photodiodes à semiconducteur et plus particulièrement un procédé d'optimisation du rendement quantique de telles photodiodes.

### Exposé de l'art antérieur

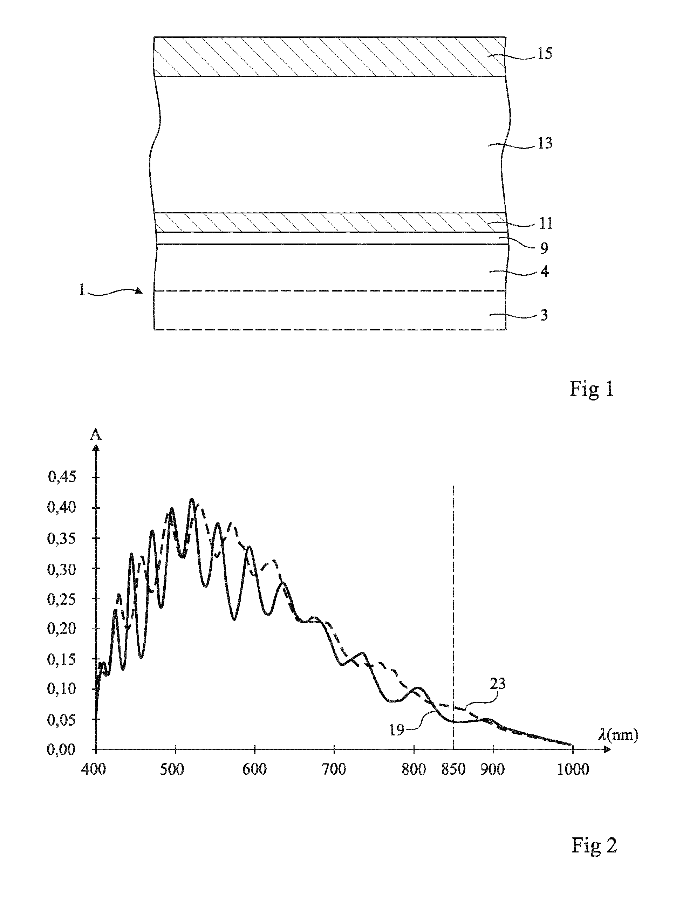

La figure 1 représente de façon simplifiée une partie soumise à éclairement, ou partie active, d'une photodiode à semiconducteur utilisée par exemple comme dispositif SPAD ("Single Photon Avalanche Diode" - diode à avalanche à photon unique). La photodiode est formée dans un substrat semiconducteur 1 en silicium comprenant une zone 3 de conversion de photons en paires électron-trou. Cette zone 3 d'un premier type de conductivité est surmontée d'une zone 4 du type de conductivité opposé. Dans une photodiode complète, il existe dans le substrat 1 d'autres jonctions (non représentées) entre des régions semiconductrices de type opposé pour stocker les électrons, et divers transistors (non représentés) pour transférer les électrons vers un circuit de lecture.

En configuration « front side », c'est-à-dire que la lumière est reçue par la face avant du substrat, la partie active de la photodiode est revêtue d'un empilement de plusieurs couches isolantes transparentes à la longueur d'onde de travail, par exemple une longueur d'onde comprise entre 700 et 1000 nm correspondant à de la lumière infrarouge. L'empilement représenté comprend successivement une couche d'oxyde de silicium 9, une couche antireflet 11, une couche épaisse d'oxyde de silicium 13 et une couche épaisse de nitrure de silicium 15. La couche épaisse 15 est la couche supérieure de l'empilement. Cette couche 15 est généralement revêtue d'une couche de filtrage et d'une microlentille (non représentées en figure 1).

De façon courante, dans une photodiode du type représenté, les épaisseurs de couches sont les suivantes :
de 1000 à 3000 nm pour le substrat semiconducteur 1,
de 500 à 2000 nm pour la zone de conversion 3,
de 500 à 1500 nm pour la zone 4,
de 5 à 50 nm pour la couche d'oxyde de silicium 9,
de 10 à 100 nm pour une couche antireflet 11 en nitrure de silicium,
de 700 à 2500 nm pour la couche d'oxyde de silicium 13 (qui peut être un empilement de plusieurs couches d'oxyde de silicium), et
de 400 à 700 nm pour la couche de nitrure de silicium 15.

Dans le cas d'une diode infrarouge, il faut une épaisseur de silicium de l'ordre de 50 µm pour absorber 95 % de la lumière reçue, ce qui est beaucoup plus épais que les épaisseurs classiques des couches utilisées en microélectronique. De plus, la photodiode infrarouge fait souvent partie d'un ensemble de photodiodes de détection de lumière visible (rouge, bleu, vert) et la zone 3 de conversion de photons en paires électron-trou est relativement mince et donc mal adaptée à la détection de lumière infrarouge. Ainsi, dans le cas où des rayons lumineux dans le domaine de l'infrarouge traversent l'empilement puis pénètrent dans le substrat semiconducteur 1, les photons ne sont que très partiellement absorbés sur l'épaisseur de l'ordre de 500 à 2000 nm de la zone de conversion. Pour une épaisseur de la zone de conversion 3 égale à 1500 nm, le rendement quantique est de l'ordre de 5 à 6 % seulement.

Il serait souhaitable d'augmenter ce rendement quantique.

### Résumé

Ainsi, un mode de réalisation prévoit un procédé d'optimisation du rendement quantique d'une photodiode dont la partie active est formée dans un substrat en silicium et est recouverte d'un empilement de couches isolantes transparentes à une longueur d'onde infrarouge, ledit empilement comprenant successivement au moins une première couche d'oxyde de silicium dont l'épaisseur est comprise entre 5 et 50 nm, une couche antireflet dont l'épaisseur est comprise entre 10 et 80 nm, et une deuxième couche d'oxyde de silicium, le procédé d'optimisation comprenant les étapes suivantes :
déterminer pour ladite longueur d'onde infrarouge des premières épaisseurs de la deuxième couche correspondant à des maxima d'absorption de la photodiode, une pseudo-période séparant deux maxima successifs, et
choisir, parmi les premières épaisseurs, une épaisseur désirée, eoxD, pour que la dispersion maximale de fabrication, D*eoxD, soit inférieure à la moitié de la pseudo-période, D étant un taux de dispersion de fabrication.

Selon un mode de réalisation, la deuxième couche d'oxyde de silicium est revêtue d'une couche de nitrure de silicium d'une épaisseur inférieure à 50 nm.

Selon un mode de réalisation, la longueur d'onde infrarouge est comprise entre 700 et 1000 nm.

Selon un mode de réalisation, l'épaisseur du substrat est comprise entre 1 et 3 µm.

Selon un mode de réalisation, la couche antireflet est en nitrure de silicium.

Selon un mode de réalisation, la longueur d'onde infrarouge est égale à 850 nm, le taux de dispersion est égal à 0,1, l'épaisseur de la première couche d'oxyde de silicium est de 25 nm, l'épaisseur de la couche antireflet est de 50 nm et l'épaisseur désirée eoxD choisie pour la deuxième couche d'oxyde de silicium est de 60 nm, 340 nm ou 640 nm.

Un mode de réalisation prévoit un procédé de fabrication d'une photodiode de rendement quantique optimisé comprenant les étapes suivantes :
a) prévoir une photodiode dont la partie active est formée dans un substrat en silicium et est recouverte d'un empilement de couches isolantes transparentes à une longueur d'onde infrarouge, l'empilement comprenant successivement au moins une première couche d'oxyde de silicium, une couche antireflet, une deuxième couche d'oxyde de silicium d'une épaisseur supérieure ou égale à une épaisseur désirée eoxD, une couche d'arrêt de gravure, et une troisième couche d'oxyde de silicium ; et
b) graver ledit empilement jusqu'à la couche d'arrêt de gravure.

Selon un mode de réalisation, le procédé comprend en outre l'étape consistant à graver la couche d'arrêt de gravure.

Selon un mode de réalisation, l'épaisseur de la deuxième couche est supérieure à l'épaisseur désirée eoxD, le procédé comprenant en outre l'étape consistant à graver partiellement la deuxième couche de façon à laisser en place une portion d'épaisseur désirée eoxD.

Selon un mode de réalisation, la couche d'arrêt de gravure est en nitrure de silicium.

Un mode de réalisation prévoit une photodiode dont la partie active est formée dans un substrat en silicium et est recouverte d'un empilement de couches isolantes transparentes à une longueur d'onde infrarouge, ledit empilement comprenant successivement au moins :
une première couche d'oxyde de silicium dont l'épaisseur est comprise entre 5 et 50 nm, et
une deuxième couche d'oxyde de silicium, ladite deuxième couche ayant une épaisseur correspondant, pour ladite longueur d'onde infrarouge, à l'un des maxima d'absorption de la photodiode, une pseudo-période séparant deux maxima successifs, ladite épaisseur étant telle que la dispersion maximale de fabrication, D*eoxD, soit inférieure à la moitié de la pseudo-période, D étant un taux de dispersion de fabrication.

Selon un mode de réalisation, la photodiode comprend, entre les première et deuxième couches d'oxyde de silicium, une couche antireflet d'épaisseur comprise entre 10 et 80 nm.

Selon un mode de réalisation, la photodiode comprend en dehors de ladite zone active un réseau d'interconnexion comprenant un empilement de portions de couches d'oxyde de silicium, de couches barrière de diffusion et d'au moins un métal.

Selon un mode de réalisation, le haut de ladite deuxième couche est au niveau de la face inférieure de l'une des portions de couches barrière de diffusion.

Selon un mode de réalisation, la portion de couche barrière de diffusion au niveau de laquelle s'arrête ladite deuxième couche est maintenue au-dessus de ladite deuxième couche.

Selon un mode de réalisation, le haut de ladite deuxième couche est au-dessous du niveau de la face inférieure de l'une des portions de couches barrière de diffusion.

Selon un mode de réalisation, le haut de ladite deuxième couche est au-dessus du niveau de la face inférieure de l'une des portions de couches barrière de diffusion.

Selon un mode de réalisation, ladite une des portions de couches barrière de diffusion est une portion de la couche barrière de diffusion la plus basse du réseau d'interconnexion.

Selon un mode de réalisation, les couches barrière de diffusion sont en nitrure de silicium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, représente schématiquement un exemple de partie active d'une photodiode ;
la figure 2 représente le taux d'absorption en fonction de la longueur d'onde pour deux photodiodes du type de celle de la figure 1 ;
la figure 3 représente, en fonction de l'épaisseur d'une couche de revêtement et pour une longueur d'onde donnée, le taux d'absorption pour deux photodiodes du type de celle de la figure 1 ;
les figures 4A et 4B illustrent des étapes successives de fabrication d'une photodiode à rendement quantique amélioré ; et
la figure 5 illustre une variante de la photodiode de la figure 4B.

Par souci de clarté, de mêmes éléments ont été désignés par de mêmes références aux différentes figures et les diverses figures ne sont pas tracées à l'échelle.

### Description détaillée

Comme on le verra en détail ci-après, les inventeurs ont étudié la variation du rendement quantique d'une photodiode en fonction de divers paramètres. Ils ont noté que ce rendement quantique ne dépend pas seulement de l'épaisseur de la zone de conversion de cette photodiode, mais aussi de la nature des couches isolantes de l'empilement situé au-dessus de la partie active ainsi que des épaisseurs de ces couches.

La figure 2 représente le taux d'absorption A de deux photodiodes différentes en fonction de la longueur d'onde λ de la lumière incidente. Dans ces deux photodiodes du type de celle de la figure 1, la couche épaisse d'oxyde de silicium 13 a une épaisseur de 2150 nm.

La courbe 19 correspond à une photodiode dans laquelle toutes les couches de l'empilement représenté en figure 1 ont été conservées. La courbe 23 correspond à une photodiode dans laquelle la couche épaisse de nitrure de silicium 15 a été supprimée.

Pour des longueurs d'onde comprises entre 740 et 790 nm ou entre 820 et 880 nm, la photodiode de la courbe 23 a un taux d'absorption plus élevé que celui de la photodiode de la courbe 19. En d'autres termes, des photodiodes du type de celle de la figure 1 dans lesquelles la couche épaisse de nitrure de silicium 15 a été supprimée ont un taux d'absorption plus élevé que des photodiodes dans lesquelles la couche épaisse 15 de nitrure de silicium a été laissée en place.

Les courbes 19 et 23 ont été obtenues pour des photodiodes dans lesquelles les couches ont des épaisseurs égales à :
1500 nm pour la zone de conversion 3,
1000 nm pour la zone 4,
25 nm pour la couche 9,
50 nm pour la couche 11,
2150 nm pour la couche épaisse d'oxyde de silicium 13, et
500 nm pour la couche épaisse de nitrure de silicium 15 lorsque celle-ci est présente.

Pour une longueur d'onde de travail égale à 850 nm, le taux d'absorption de la photodiode correspondant à la courbe 19 est égal à 4,5 % alors que le taux d'absorption de la photodiode correspondant à la courbe 23 est plus élevé et égal à 6,5 %. Ainsi, la suppression de la couche épaisse 15 de nitrure de silicium dans une photodiode du type de celle de la figure 1 permet un gain d'absorption.

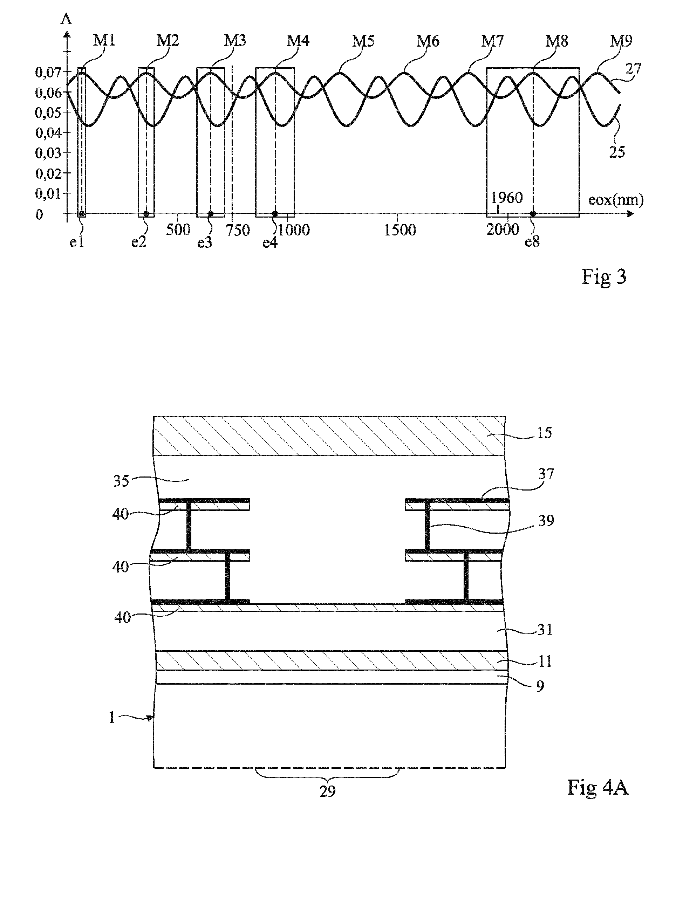

La figure 3 représente, pour une longueur d'onde égale à 850 nm, le taux d'absorption A de deux photodiodes du type de celle de la figure 1 en fonction de l'épaisseur eox de la couche d'oxyde de silicium 13. La courbe 25 correspond à une photodiode dans laquelle la couche épaisse (de 400 à 700 nm) de nitrure de silicium 15 a été laissée en place. La courbe 27 correspond à une photodiode dans laquelle la couche épaisse de nitrure de silicium 15 a été supprimée.

Les courbes 25 et 27 présentent des maxima et des minima d'absorption sensiblement périodiques, de pseudo-période T, ce qui montre qu'il se produit des phénomènes interférentiels. En effet, la couche d'oxyde 13 est située entre deux couches 11 et 15 de nitrure de silicium d'indice optique différent de celui de la couche 13. Il y a donc une cavité optique de type Fabry-Perot avec des multi-réflexions entre les deux couches de nitrure de silicium, d'où l'apparition d'oscillations dans les courbes 25 et 27. Ces oscillations correspondent aux interférences dans la cavité optique, qui sont constructives ou destructives selon la longueur d'onde et selon l'épaisseur. Lorsqu'on supprime la couche 15, on réduit fortement la réflexion et les oscillations sont d'amplitude plus faible, ce qu'on voit sur la courbe 27. Elles sont cependant encore présentes car une faible réflexion subsiste à l'interface entre la couche 13 d'oxyde de silicium et l'air. Les valeurs des maxima M1 à M9 de la courbe 27 sont sensiblement identiques aux valeurs des maxima de la courbe 25, et même légèrement plus élevées pour la courbe 27 que pour la courbe 25. L'absorption moyenne est égale à 5,5 % et 6,28 %, respectivement, pour les courbes 25 et 27.

Il ressort de cette première analyse des courbes 25 et 27 qu'il est préférable de se trouver dans des conditions correspondant à la courbe 27 (absence d'une couche épaisse de nitrure de silicium 15) car alors l'absorption de la zone de conversion sera en moyenne plus élevée que dans les conditions correspondant à la courbe 25 (présence d'une couche épaisse de nitrure de silicium 15).

Il apparaît également qu'il est préférable de choisir une épaisseur de la couche d'oxyde de silicium 13 correspondant à un maximum d'absorption, et de préférence à un maximum d'absorption de la courbe 27. Toutefois, en raison des dispersions de fabrication, il n'est généralement pas possible d'obtenir très exactement une couche d'oxyde de silicium d'une épaisseur désirée eox_{D}. En effet, quand on cherche à fabriquer des couches d'une épaisseur désirée eox_{D}, on obtient des couches ayant des épaisseurs effectives obtenues eox_{O} comprises entre eox_{D}-D*eox_{D} et eox_{D}+D*eox_{D}, D étant un taux de dispersion de fabrication pouvant couramment atteindre une valeur de l'ordre de 0,1.

Ainsi, si on veut que l'épaisseur effective eox_{O} corresponde à une valeur d'absorption proche d'un maximum d'absorption, en plus de choisir eox_{D} correspondant à un maximum d'absorption, il convient que le spectre des épaisseurs effectives eox_{O} résultant des dispersions de fabrication, soit nettement inférieur à la pseudo-période T des courbes d'absorption.

A titre d'exemple, si le taux de dispersion D est égal à 0,1 et que la pseudo-période T est égale à 300 nm, il convient que l'épaisseur désirée eox_{D} corresponde à un maximum d'absorption et que 2*D*eox_{D} soit nettement inférieur à 300 nm, par exemple inférieur à la moitié de 300 nm.

En se référant à la figure 3 et en considérant un taux de dispersion de fabrication maximal D=0,1, pour que 2*D*eox_{D} soit inférieur par exemple à 150 nm, eox_{D} devra être inférieur à 750 nm. Ainsi, si on considère les premiers maxima M1, M2, M3 de la courbe 27, les épaisseurs correspondantes de la couche 13 d'oxyde de silicium sont respectivement e1=60 nm, e2=340 nm et e3=640 nm et sont inférieures à 750 nm. En visant la fabrication d'une couche 13 d'une épaisseur désirée eox_{D} égale à e1, e2 ou e3, l'épaisseur effective eox_{O} sera comprise respectivement entre 54 et 66 nm, entre 306 et 374 nm ou entre 576 et 704 nm. Les taux d'absorption correspondant à ces épaisseurs effectives eox_{O} seront alors proches du maximum d'absorption.

Au contraire, si on considère les maxima M4 et M8, les épaisseurs correspondantes de la couche 13 sont respectivement e4=940 nm et e8=2100 nm. En visant la fabrication d'une couche 13 d'une épaisseur désirée eox_{D} égale à e4 ou e8, l'épaisseur effective eox_{O} sera comprise respectivement entre 845 et 1035 nm ou entre 1890 et 2310 nm. Les taux d'absorption correspondant à ces épaisseurs effectives obtenues eox_{O} pourront être éloignés du maximum d'absorption, et dans le pire des cas pourront correspondre à un minimum d'absorption, par exemple quand eox_{O}=1960 nm.

Ainsi, dans le cas où l'épaisseur désirée eox_{D} correspond à une couche d'oxyde de silicium 13 assez mince, c'est-à-dire que 2*D*eox_{D} est inférieur à la pseudo-période T, le choix d'une épaisseur eox_{D} correspondant à un maximum d'absorption, de préférence de la courbe 27, permet d'améliorer le taux d'absorption d'une photodiode du type de celle de la figure 1 nonobstant les dispersions de fabrication.

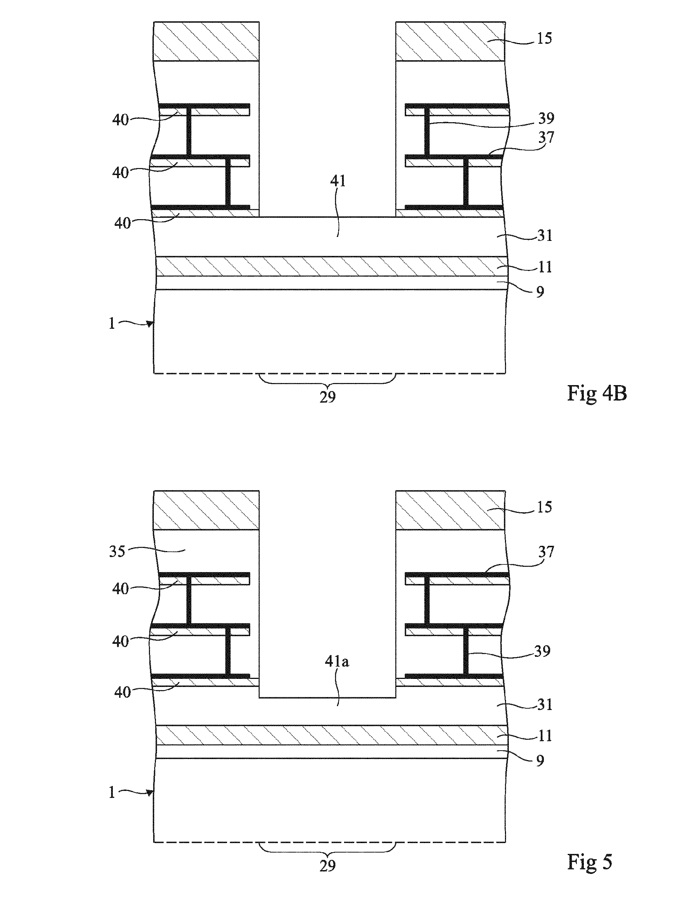

Les figures 4A et 4B illustrent un exemple d'étapes successives de fabrication d'une photodiode dans laquelle l'absorption est optimisée selon le procédé décrit ci-dessus.

A l'étape illustrée en figure 4A, une partie active 29 d'une photodiode, c'est-à-dire la partie soumise à éclairement, est formée dans un substrat semiconducteur 1 en silicium. La partie active 29 de la photodiode est revêtue d'un empilement de plusieurs couches isolantes transparentes à la longueur d'onde de travail. L'empilement représenté comprend successivement, dans des réalisations courantes telles qu'illustrées en figure 1, une couche d'oxyde de silicium 9, une couche antireflet 11, une couche d'oxyde de silicium 31, une couche d'oxyde de silicium 35 et une couche épaisse de nitrure de silicium 15.

Des niveaux de métal 37 sont prévus dans la couche 35, en dehors de la partie active 29. Les niveaux de métal 37 sont éventuellement reliés par des vias 39. On notera que des vias (non représentés) viennent contacter des éléments formés dans le substrat de silicium 1. La représentation de ces niveaux de métal et de ces vias est purement symbolique. Sous chaque niveau de métal 37 est formée une couche 40 servant de barrière de diffusion, couramment en nitrure de silicium. De façon générale, ces couches 40 sont interrompues en regard de la partie active 29. On prévoit ici que l'une des couches 40 est maintenue en place en regard de la partie active, la couche la plus basse dans l'exemple représenté.

La figure 4B représente une photodiode obtenue après élimination par gravure des portions des couches 15, 35 et 40 en regard de la partie active 29 de la photodiode. La portion de la couche 40 en regard de la partie active sert alors de couche d'arrêt de gravure lors de la gravure de la couche d'oxyde de silicium 35.

Selon un mode de réalisation, l'épaisseur de la couche 31 sous la couche de nitrure de silicium 40 maintenue provisoirement en place a été choisie préalablement pour être égale à une épaisseur désirée eox_{D} correspondant à un maximum d'absorption, par exemple une épaisseur eox_{D} égale à eox2. On obtient alors une photodiode dont la partie active 29 est revêtue successivement des couches 9, 11 et d'une portion 41 de la couche d'oxyde de silicium 31 dont l'épaisseur effective eox_{O} est égale, aux dispersions de fabrication près, à l'épaisseur désirée eox_{D} maximisant l'absorption.

La figure 5 illustre une variante de la photodiode de la figure 4B. Après les étapes conduisant à la structure de la figure 4B, une étape supplémentaire de gravure est réalisée dans le cas où l'épaisseur de la couche 31 est supérieure à une épaisseur désirée eox_{D} maximisant l'absorption. Cette étape de gravure est réalisée pour laisser en place, en regard de la partie active 29, une portion 41a de la couche 31 d'épaisseur désirée eox_{D}. On obtient alors une photodiode dont la partie active 29 est revêtue successivement des couches 9 et 11 et d'une portion 41a de la couche d'oxyde de silicium 31 dont l'épaisseur effective obtenue eox_{O} est égale, aux dispersions de fabrication près, à l'épaisseur désirée eox_{D} maximisant l'absorption. A titre de variante, dans le cas où l'épaisseur de la couche 31 est inférieure à une épaisseur désirée, on pourra redéposer de l'oxyde pour atteindre la valeur désirée.

Des modes de réalisation particuliers ont été décrits. Diverses variantes et modifications apparaîtront à l'homme de l'art. En particulier, une ou plusieurs couches de filtrage et une microlentille seront habituellement formées sur la portion 41 de la couche 31.

Les étapes de fabrication décrites en relation avec les figures 4A, 4B et 5 sont susceptibles de nombreuses variantes. Par exemple, à l'étape représentée en figure 4B, la portion de la couche barrière 40 en regard de la partie active de la photodiode peut être laissée en place, par exemple pour éviter une possible dégradation de l'oxyde de silicium de la couche 31 lors de la gravure de cette portion de la couche 40. Dans ce cas, l'épaisseur des couches 31 et 40 est choisie préalablement pour correspondre à un maximum d'absorption.

Bien que l'on ait décrit une étape de fabrication d'une photodiode dans laquelle la couche 40 la plus basse est maintenue en place en regard de la partie active, on peut choisir de maintenir en place une autre des couches 40 et d'interrompre la couche 40 la plus basse.

Bien que l'on ait plus particulièrement mentionné ici des photodiodes de type SPAD, on notera que les modes de réalisation décrits peuvent être adaptés à tout capteur comprenant des photodiodes éclairées par la face avant.

## Revendications

1. Procédé d'optimisation du rendement quantique d'une photodiode dont la partie active (29) est formée dans un substrat en silicium (1) et est recouverte d'un empilement de couches isolantes transparentes à une longueur d'onde infrarouge, ledit empilement comprenant successivement au moins :
une première couche (9) d'oxyde de silicium dont l'épaisseur est comprise entre 5 et 50 nm,
une couche antireflet (11) dont l'épaisseur est comprise entre 10 et 80 nm, et
une deuxième couche (13 ; 31) d'oxyde de silicium,
le procédé d'optimisation comprenant les étapes suivantes :
déterminer pour ladite longueur d'onde infrarouge des premières épaisseurs (e1, e2, e3, e4 ... e8) de la deuxième couche (13 ; 31) correspondant à des maxima d'absorption (M1, M2, M3, M4 ... M8) de la photodiode, une pseudo-période (T) séparant deux maxima successifs,
choisir, parmi les premières épaisseurs, une épaisseur désirée, eox_{D}, pour que la dispersion maximale de fabrication, D*eox_{D}, soit inférieure à la moitié de la pseudo-période (T), D étant un taux de dispersion de fabrication, et
fabriquer la photodiode, la deuxième couche ayant l'épaisseur désirée eox_{D} à D*eox_{D} près.

2. Procédé selon la revendication 1, dans lequel la deuxième couche (13 ; 31) d'oxyde de silicium est revêtue d'une couche de nitrure de silicium d'épaisseur inférieure à 50 nm.

3. Procédé selon la revendication 1 ou 2, dans lequel la longueur d'onde infrarouge est comprise entre 700 et 1000 nm.

4. Procédé selon l'une quelconque des revendications 1 à 3, dans lequel l'épaisseur du substrat (1) est comprise entre 1 et 3 µm.

5. Procédé selon l'une quelconque des revendications 1 à 4, dans lequel la couche antireflet (11) est en nitrure de silicium.

6. Procédé selon la revendication 5, dans lequel la longueur d'onde infrarouge est égale à 850 nm, le taux de dispersion (D) est égal à 0,1, l'épaisseur de la première couche (9) d'oxyde de silicium est de 25 nm, l'épaisseur de la couche antireflet (11) est de 50 nm et l'épaisseur désirée eox_{D} choisie pour la deuxième couche (13 ; 31) d'oxyde de silicium est de 60 nm, 340 nm ou 640 nm.

7. Procédé de fabrication d'une photodiode de rendement quantique optimisé par le procédé selon l'une quelconque des revendications 1 à 6, comprenant les étapes suivantes :
a) prévoir une photodiode dont la partie active (29) est formée dans un substrat en silicium (1) et est recouverte d'un empilement de couches isolantes transparentes à une longueur d'onde infrarouge, ledit empilement comprenant successivement au moins :
une première couche (9) d'oxyde de silicium,
une couche antireflet (11),
une deuxième couche (31) d'oxyde de silicium d'une épaisseur supérieure ou égale à une épaisseur désirée eox_{D},
une couche d'arrêt de gravure (40), et
une troisième couche (35) d'oxyde de silicium ; et
b) graver ledit empilement jusqu'à la couche d'arrêt de gravure (40).

8. Procédé selon la revendication 7, comprenant en outre l'étape suivante :
c) graver la couche d'arrêt de gravure (40).

9. Procédé selon la revendication 8, dans lequel l'épaisseur de la deuxième couche (31) est supérieure à l'épaisseur désirée eox_{D}, le procédé comprenant en outre l'étape suivante :
d) graver partiellement la deuxième couche (31) de façon à en laisser en place une portion (41a) d'épaisseur désirée eox_{D}.

10. Procédé selon l'une quelconque des revendications 7 à 9, dans lequel la couche d'arrêt de gravure (40) est en nitrure de silicium.
